# EUROPEAN PATENT APPLICATION

(11) **EP 3 761 078 A1**
(43) Date of publication of application: **06.01.2021**
(21) Application number: 19757962.6
(22) Date of filing: 19.02.2019
(51) Int. Cl.: G02B 5/20, C09B 23/00, C09B 67/20, G02F 1/1335, H01L 27/146

(54) **GREEN COLORED RESIN COMPOSITION**

(30) Priority: 26.02.2018 JP 2018032372
(71) Applicant: SUMITOMO CHEMICAL COMPANY LIMITED, Chuo-ku Tokyo 104-8260 (JP)
(72) Inventor: KAWANISHI, Yutaka, Osaka-shi, Osaka 554-8558 (JP)
(74) Representative: Vossius & Partner Patentanwälte Rechtsanwälte mbB
(86) International application number: PCT/JP2019/005971
(87) International publication number: WO 2019/163733

(57) **Abstract**

An object of the present invention is to provide a colored resin composition comprising a squarylium dye excellent in heat resistance. The colored resin composition according to the present invention is a green colored resin composition comprising a colorant, a resin and a solvent. The colorant contains a squarylium dye, and the content percentage of the resin is 70 mass% or more based on an amount obtained by subtracting the content of the colorant and the solvent from the total amount of the green colored resin composition.

## Description

### Technical Field

The present invention relates to a green colored resin composition, and also relates to a color filter formed of the green colored resin composition.

### Background Art

Various dyes are known as colorants contained in colored resin compositions which form color filters contained in liquid crystal display devices and solid-state image sensors. Patent Literature 1 discloses a colored resin composition containing a squarylium dye.

### Citation List

### Patent Literature

Patent Literature 1: Japanese Patent Laid-Open No. 2015-86379

### Summary of Invention

### Technical Problem

An object of the present invention is to provide a squarylium dye-containing colored resin composition superior in heat resistance to the squarylium dye-containing colored resin composition disclosed in Patent Literature 1, and a color filter formed of the colored resin composition.

### Solution to Problem

The present invention provides the following [1] to [4].
[1] A green colored resin composition comprising a colorant, a resin and a solvent, wherein
   the colorant comprises a squarylium dye, and
   the content of the resin is 70 mass% or more based on an amount obtained by subtracting the content of the colorant and the solvent from the total amount of the green colored resin composition.
[2] The green colored resin composition according to [1], wherein the squarylium dye is a compound represented by formula (II): 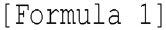 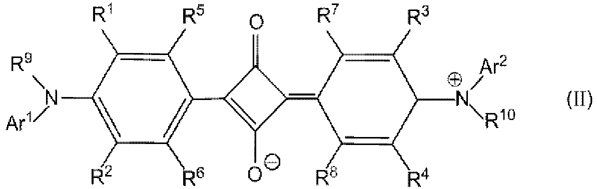
   wherein R¹ to R⁴ each independently represent a hydrogen atom, a halogen atom, a hydroxy group, or a monovalent saturated hydrocarbon group having 1 to 20 carbon atoms; a hydrogen atom or a methyl group contained in the monovalent saturated hydrocarbon group is optionally replaced by a halogen atom, a hydroxy group or an alkylamino group having 1 to 8 carbon atoms, and an oxygen atom or a sulfur atom is optionally intercalated between carbon atoms that form the monovalent saturated hydrocarbon group;
   R⁵ to R⁸ each independently represent a hydrogen atom or a hydroxy group;
   Ar¹ and Ar² each independently represent a group represented by the following formula (i):

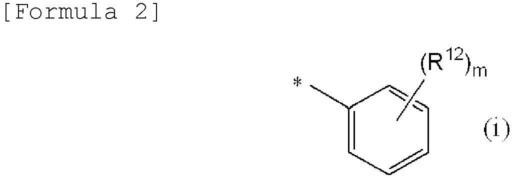

   In formula (i), R¹² represents a monovalent saturated hydrocarbon group having 1 to 20 carbon atoms, or a monovalent unsaturated hydrocarbon group having 2 to 20 carbon atoms, and m represents an integer of 1 to 5. When m is 2 or more, a plurality of R¹² may be the same or different. * represents a point of attachment to a nitrogen atom.
   R⁹ and R¹⁰ each independently represent a monovalent saturated hydrocarbon group having 1 to 20 carbon atoms, or a group represented by formula (i). A hydrogen atom or a methyl group contained in the monovalent saturated hydrocarbon group is optionally replaced by a halogen atom, a hydroxy group, or an amino group substituted with one or two alkyl groups having 1 to 8 carbon atoms, and an oxygen atom or a sulfur atom is optionally intercalated between carbon atoms that form the monovalent saturated hydrocarbon group.
[3] The green colored resin composition according to [1] or [2], wherein the colorant further comprises a dye other than a squarylium dye.
[4] A color filter formed of the green colored resin composition according to any one of [1] to [3].

### Advantageous Effect of Invention

The green colored resin composition of the present invention is excellent in heat resistance.

### Description of Embodiments

A colored resin composition of the present invention contains a colorant (A), a resin (B) and a solvent (E). If necessary, the colored resin composition of the present invention may contain additives known in the art, such as a leveling agent (F), a filler, other polymer compounds, an adhesion promoting agent, an antioxidant, a light stabilizer and a chain transfer agent. The colored resin composition of the present invention contains a squarylium dye as the colorant (A), and is preferably a green colored resin composition. The ingredients will be described in detail below. Herein, compounds shown as each ingredient can be used singly or in combinations of a plurality thereof unless otherwise specified.

### <Colorant (A)>

### (Dye (A-1))

The colorant (A) contains a squarylium dye (hereinafter, sometimes referred to as a dye (A-1)). The squarylium dye can be used without being particularly limited as long as it has a structure represented by formula (I).

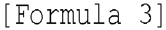

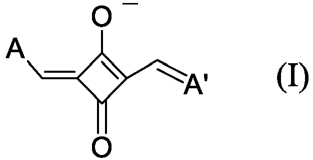

In formula (I), A and A' each independently represent an organic group containing an aromatic ring or a heterocyclic ring. The compounds represented by formula (I) include compounds having any possible resonance structures with respect to the structure represented by formula (I).

Examples of the squarylium dye represented by formula (I) include the compounds disclosed in Japanese Patent Laid-Open No. 2013-76926. Among the compounds represented by formula (I), compounds represented by formula (II) (hereinafter, sometimes referred to as "compounds (II)") are preferable as the squarylium dye.

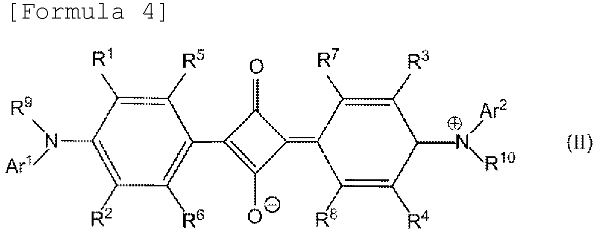

In formula (II), R¹ to R⁴ each independently represent a hydrogen atom, a halogen atom, a hydroxy group, or a monovalent saturated hydrocarbon group having 1 to 20 carbon atoms. A hydrogen atom or a methyl group contained in the monovalent saturated hydrocarbon group is optionally replaced by a halogen atom, a hydroxy group or an alkylamino group having 1 to 8 carbon atoms, and an oxygen atom or a sulfur atom is optionally intercalated between carbon atoms that form the monovalent saturated hydrocarbon group.

R⁵ to R⁸ each independently represent a hydrogen atom or a hydroxy group.

Ar¹ and Ar² each independently represent a group represented by the following formula (i).

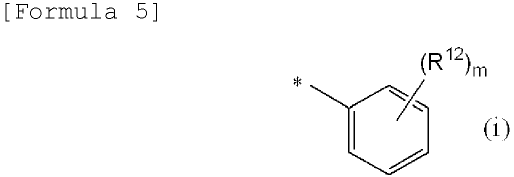

In formula (i), R¹² represents a monovalent saturated hydrocarbon group having 1 to 20 carbon atoms, or a monovalent unsaturated hydrocarbon group having 2 to 20 carbon atoms, and m represents an integer of 1 to 5. When m is 2 or more, a plurality of R¹² may be the same or different. * represents a point of attachment to a nitrogen atom.

R⁹ and R¹⁰ each independently represent a monovalent saturated hydrocarbon group having 1 to 20 carbon atoms, or a group represented by formula (i). A hydrogen atom or a methyl group contained in the monovalent saturated hydrocarbon group is optionally replaced by a halogen atom, a hydroxy group, or an amino group substituted with one or two alkyl groups having 1 to 8 carbon atoms, and an oxygen atom or a sulfur atom is optionally intercalated between carbon atoms that form the monovalent saturated hydrocarbon group.

In formula (II), examples of the halogen atom in R¹ to R⁴ include a fluorine atom, a chlorine atom, a bromine atom and an iodine atom.

Examples of the monovalent saturated hydrocarbon group having 1 to 20 carbon atoms in R¹ to R⁴, R⁹, R¹⁰ and R¹² include linear alkyl groups having 1 to 20 carbon atoms, such as a methyl group, an ethyl group, a propyl group, a butyl group, a pentyl group, a hexyl group, a heptyl group, an octyl group, a nonyl group, a decyl group, a dodecyl group, a hexadecyl group and an icosyl group; branched alkyl groups having 3 to 20 carbon atoms, such as an isopropyl group, an isobutyl group, a sec-butyl group, a tert-butyl group, an isopentyl group, a neopentyl group and a 2-ethylhexyl group; and cycloaliphatic saturated hydrocarbon groups having 3 to 20 carbon atoms, such as a cyclopropyl group, a cyclopentyl group, a cyclohexyl group, a cyclopentyl group, a cyclooctyl group and a tricyclodecyl group.

Examples of the group in which a hydrogen atom or a methyl group contained in the saturated hydrocarbon group is replaced by a halogen atom, a hydroxy group or an amino group substituted with one or two alkyl groups having 1 to 8 carbon atoms include groups of the following formulas. Here, examples of the amino group substituted with one or two alkyl groups having 1 to 8 carbon atoms include a methylamino group, an ethylamino group, a n-propylamino group, a n-butylamino group, a n-pentylamino group, a dimethylamino group, a diethylamino group, a dibutylamino group and a methylethylamino group. In the following formulas, * represents a point of attachment.

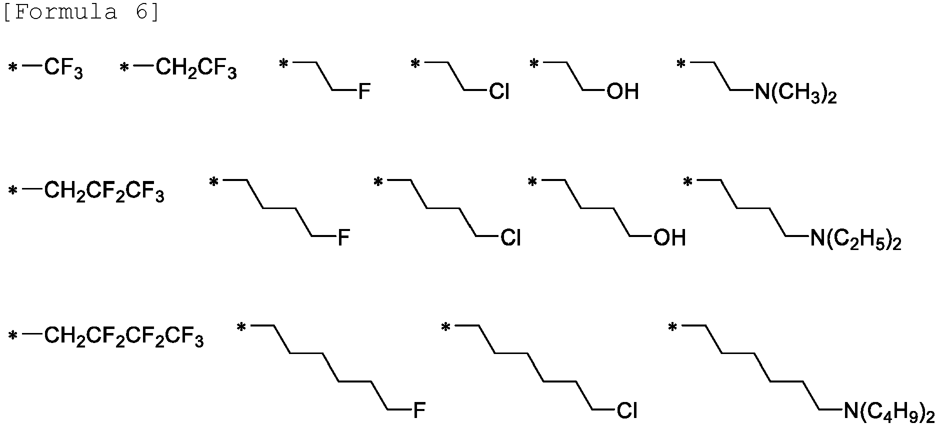

Examples of the group in which an oxygen atom or a sulfur atom is intercalated between carbon atoms that form the saturated hydrocarbon group include groups represented by the following formulas. In the following formulas, * represents a point of attachment.

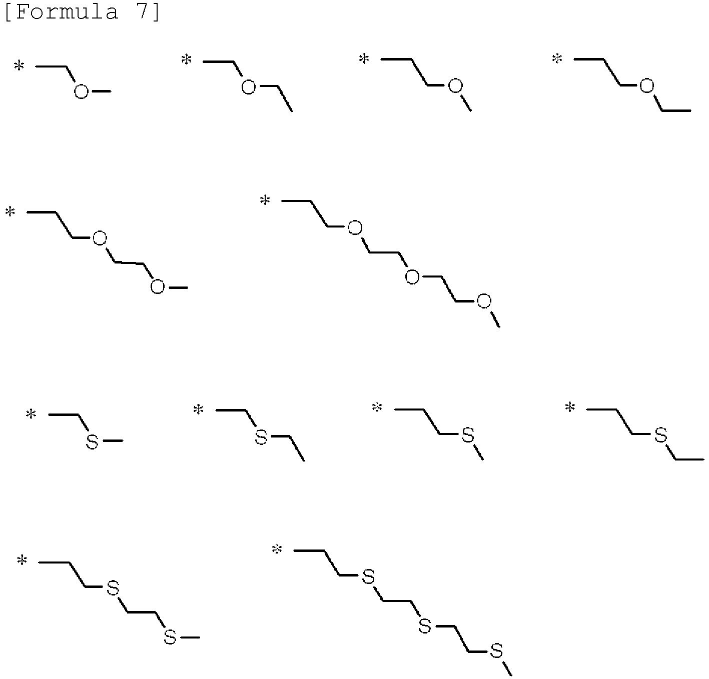

Examples of the monovalent unsaturated hydrocarbon group having 2 to 20 carbon atoms in R¹² include a vinyl group, a propenyl group, a butenyl group, a pentenyl group, a hexenyl group, a heptenyl group, an octenyl group, a nonenyl group and a decenyl group.

Examples of the group represented by formula (i) include the following groups. * represents a point of attachment to a nitrogen atom.

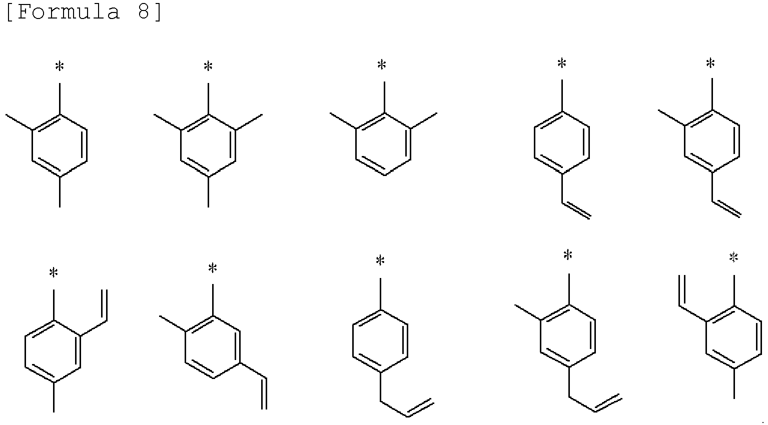

R¹ to R⁴ are each preferably a hydrogen atom, a hydroxy group or a methyl group, more preferably a hydrogen atom.

R⁹ and R¹⁰ are each preferably an octyl group, a nonyl group, a decyl group, a dodecyl group, a 2-ethylhexyl group or a group represented by formula (i), more preferably a 2-ethylhexyl group.

R¹² is preferably an alkyl group having 1 to 4 carbon atoms, more preferably a methyl group or an ethyl group.

wherein X¹ is a group of the formula: 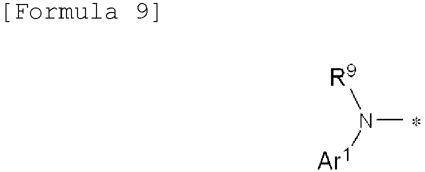 , and X² is a group of the formula: 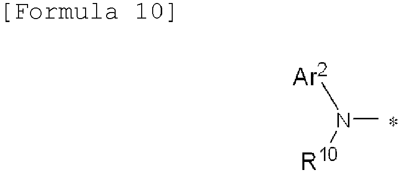 , examples of the groups of X¹ and X² include groups represented by formulas (A2-1) to (A2-7). * represents a point of attachment to a carbon atom.

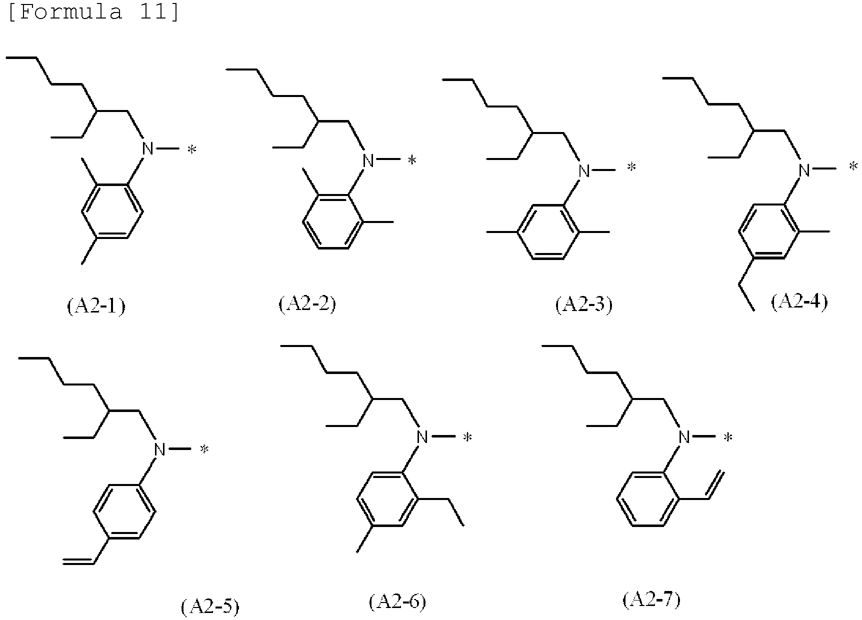

Examples of the compound represented by formula (II) include compound (AII-1) to compound (AII-21) shown in Table 1.

**[Table 1]**

| Compound | R¹ | R² | R³ | R⁴ | R⁵ | R⁶ | R⁷ | R⁸ | X¹ | X² |
|---|---|---|---|---|---|---|---|---|---|---|
| AII-1 | H | H | H | H | H | H | H | H | A2-1 | A2-1 |
| AII-2 | H | H | H | H | H | H | H | H | A2-2 | A2-2 |
| AII-3 | H | H | H | H | H | H | H | H | A2-3 | A2-3 |
| AII-4 | H | H | H | H | H | H | H | H | A2-4 | A2-4 |
| AII-5 | H | H | H | H | H | H | H | H | A2-5 | A2-5 |
| AII-6 | H | H | H | H | H | H | H | H | A2-6 | A2-6 |
| AII-7 | H | H | H | H | H | H | H | H | A2-7 | A2-7 |
| AII-8 | H | H | H | H | OH | OH | H | H | A2-1 | A2-1 |
| AII-9 | H | H | H | H | OH | OH | H | H | A2-2 | A2-2 |
| AII-10 | H | H | H | H | OH | OH | H | H | A2-3 | A2-3 |
| AII-11 | H | H | H | H | OH | OH | H | H | A2-4 | A2-4 |
| AII-12 | H | H | H | H | OH | OH | H | H | A2-5 | A2-5 |
| AII-13 | H | H | H | H | OH | OH | H | H | A2-6 | A2-6 |
| AII-14 | H | H | H | H | OH | OH | H | H | A2-7 | A2-7 |
| AII-15 | H | H | H | H | OH | OH | OH | OH | A2-1 | A2-1 |
| AII-16 | H | H | H | H | OH | OH | OH | OH | A2-2 | A2-2 |
| AII-17 | H | H | H | H | OH | OH | OH | OH | A2-3 | A2-3 |
| AII-18 | H | H | H | H | OH | OH | OH | OH | A2-4 | A2-4 |
| AII-19 | H | H | H | H | OH | OH | OH | OH | A2-5 | A2-5 |
| AII-20 | H | H | H | H | OH | OH | OH | OH | A2-6 | A2-6 |
| AII-21 | H | H | H | H | OH | OH | OH | OH | A2-7 | A2-7 |

From the viewpoint of raw material availability, the compounds (AII-8) to (AII-14) are more preferable, and the compound (AII-8) is particularly preferable.

The compound (II) of the present invention can be produced by, for example, the method disclosed in Japanese Patent Laid-Open No. 2002-363434, specifically a method in which a compound represented by formula (IV-1) is reacted with squaric acid (3,4-dihydroxy-3-cyclobutene-1,2-dione).

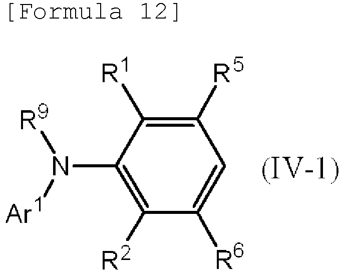

In formula (IV-1), R¹, R², R⁵, R⁶, R⁹ and Ar¹ each have the same meaning as described above.

The amount of squaric acid used is preferably 0.5 mol or more and 0.8 mol or less, more preferable 0.55 mol or more and 0.6 mol or less, per mol of the compound represented by formula (IV-1).

The reaction temperature is preferably 30°C to 180°C, more preferably 80°C to 140°C. The reaction time is preferably 1 hour to 12 hours, more preferably 3 hours to 8 hours.

Preferably, the reaction is carried out in an organic solvent from the viewpoint of yield. Examples of the organic solvent include hydrocarbon solvents such as toluene and xylene; halogenated hydrocarbon solvents such as chlorobenzene, dichlorobenzene and chloroform; alcohol solvents such as methanol, ethanol, isopropanol and butanol; nitrohydrocarbon solvents such as nitrobenzene; ketone solvents such as methyl isobutyl ketone; and amide solvents such as 1-methyl-2-pyrrolidone, and a mixture of any of these solvents may be used. In particular, mixed solvents of butanol and toluene are preferable. The amount of the organic solvent used is preferably 30 parts by mass or more and 200 parts by mass or less, more preferably 50 parts by mass or more and 150 parts by mass or less per mol of the compound represented by formula (IV-1).

The method for obtaining a compound (II) as a target compound from the reaction mixture is not particularly limited, and various known methods can be employed. For example, a method may be mentioned in which crystals precipitated after cooling are taken by filtration. Preferably, the crystals taken by filtration are washed with water etc., and then dried. If necessary, the crystals may be further purified by a known method such as recrystallization.

The compound represented by formula (IV-1) can be produced by reacting a compound represented by formula (IV-2) with a compound represented by formula (IV-3) to produce a compound represented by formula (IV-4), and then reacting the compound represented by formula (IV-4) with a compound represented by formula (IV-5).

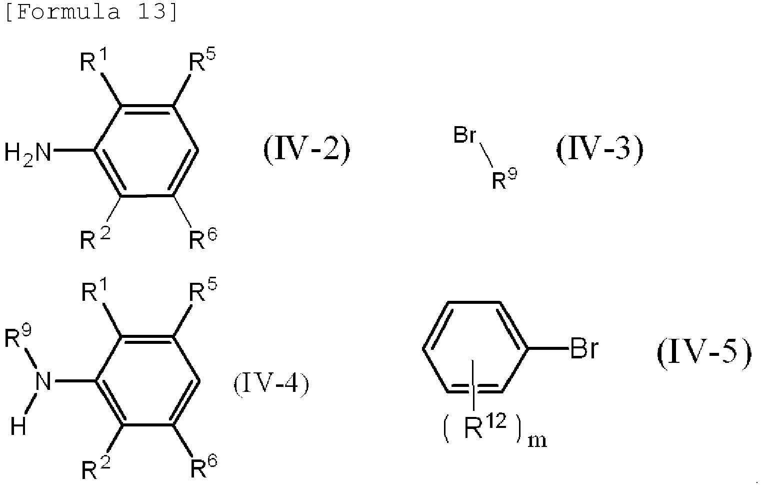

In formula (IV-2) to formula (IV-5), R¹, R², R⁵, R⁶, R⁹, R¹² and m each have the same meaning as described above.

Examples of methods for producing the compound represented by formula (IV-4) from the compound represented by formula (IV-2) and the compound represented by formula (IV-3) include various known methods, for example the method disclosed in Eur. J. org. Chem. 2012, 3105-3111.

Examples of methods for producing the compound represented by formula (IV-1) from the compound represented by formula (IV-4) and the compound represented by formula (IV-5) include various known methods, for example the method disclosed in J. Polymer Science Part A: Polymer Chemistry 2012, 50, 3788-3796.

The content of the dye (A-1) is 1 to 100 mass%, preferably 3 to 99.9 mass%, based on the total amount of the colorant.

### (Other Colorant Ingredients)

The colorant (A) may contain, in addition to the dye (A-1), a dye other than the dye (A-1) (hereinafter, sometimes referred to as a dye (A-2)), a pigment (P) or a mixture thereof for color matching, i.e. for adjustment of spectral characteristics. The dye (A-2) is not limited as long as it is a dye other than a squarylium dye, and examples of the dye (A-1) include dyes such as oil-soluble dyes, acidic dyes, amine salts of acidic dyes and sulfonamide derivatives of acidic dyes, for example compounds classified as dyes in Color Index International (Journal of The Society of Dyers and Colourists), and known dyes disclosed in Dyeing Note (Shikisensha Co., Ltd.). Examples of the second dye classified in terms of chemical structures include coumarin dyes, gold-containing azo dyes, pyridine azo dyes, barbituric azo dyes, quinophthalone dyes, methine dyes, cyanine dyes, anthraquinone dyes, triphenylmethane dyes, xanthene dyes and phthalocyanine dyes. These dyes may be used singly or in combinations of two or more thereof.

Specific examples include C.I. solvent dyes such as C.I. Solvent Yellow 4 (hereinafter, "C.I. Solvent Yellow" is omitted, and only the numbers are described), 14, 15, 23, 24, 38, 62, 63, 68, 82, 94, 98, 99 and 162, and C.I. Solvent Oranges 2, 7, 11, 15, 26 and 56; C.I. acid dyes such as C.I. Acid Yellows 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243 and 251, and C.I. Acid Oranges 6, 7, 8, 10, 12, 26, 50, 51, 52, 56, 62, 63, 64, 74, 75, 94, 95, 107, 108, 169 and 173;

C.I. direct dyes such as C.I. Direct Yellows 2, 33, 34, 35, 38, 39, 43, 47, 50, 54, 58, 68, 69, 70, 71, 86, 93, 94, 95, 98, 102, 108, 109, 129, 136, 138 and 141, and C.I. Direct Oranges 34, 39, 41, 46, 50, 52, 56, 57, 61, 64, 65, 68, 70, 96, 97, 106 and 107; and C.I. mordant dyes such as C.I. Mordant Yellows 5, 8, 10, 16, 20, 26, 30, 31, 33, 42, 43, 45, 56, 61, 62 and 65, and C.I. Mordant Oranges 3, 4, 5, 8, 12, 13, 14, 20, 21, 23, 24, 28, 29, 32, 34, 35, 36, 37, 42, 43, 47 and 48.

The second dye (A-2) is preferably a yellow dye such as a coumarin dye, a gold-containing azo dye, a pyridine azo dye, a barbituric azo dye, a quinophthalone dye, a methine dye or a cyanine dye. It is preferable that the colorant contain a yellow dye because the lightness of the resulting color filter can be enhanced.

Examples of the yellow dye include compounds shown below.

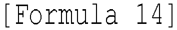

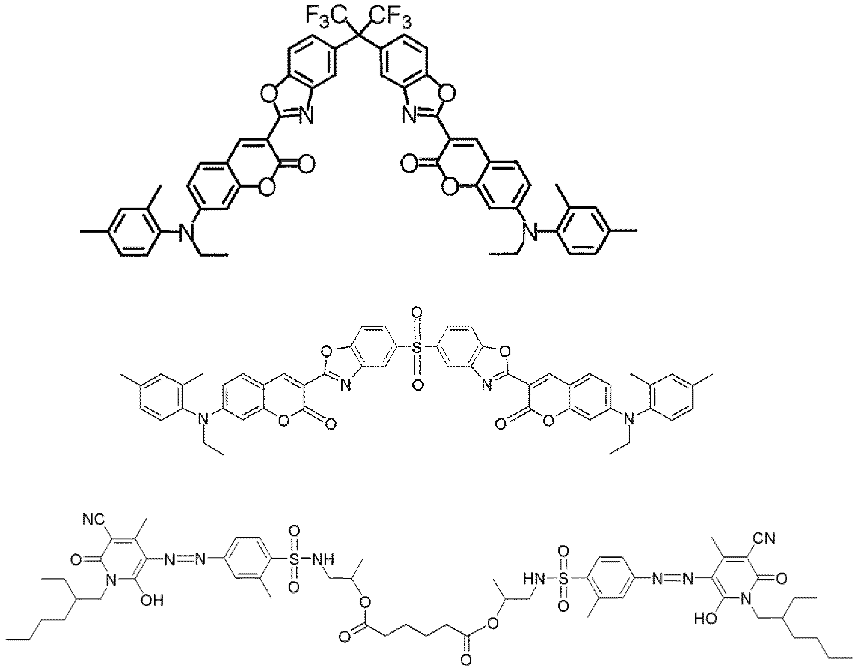

When the colorant (A) of the colored resin composition contains the dye (A-2), the content of the dye (A-2) is 3 to 99 mass%, preferably 4 to 98 mass%, based on the total amount of the colorant. The content of the dye (A-2) is preferably within the above-described range because the color value is easily adjusted. It is preferable that the colorant contain a yellow dye as the dye (A-2) and the content of the yellow dye be within the above-described range because the lightness of the resulting color filter can be enhanced.

The pigment (P) is not particularly limited, and a known pigment can be used. Examples thereof include pigments classified as pigments in Color Index International (Journal of The Society of Dyers and Colourists).

Examples thereof include yellow pigments such as C.I. Pigment Yellows 1, 3, 12, 13, 14, 15, 16, 17, 20, 24, 31, 53, 83, 86, 93, 94, 109, 110, 117, 125, 128, 137, 138, 139, 147, 148, 150, 153, 154, 166, 173, 194 and 214; orange-colored pigments such as C.I. Pigment Oranges 13, 31, 36, 38, 40, 42, 43, 51, 55, 59, 61, 64, 65, 71 and 73; and green pigments such as C.I. Pigment Greens 7, 36 and 58.

As the pigment (P), yellow pigments such as C.I. Pigment Yellows 1, 3, 12, 13, 14, 15, 16, 17, 20, 24, 31, 53, 83, 86, 93, 94, 109, 110, 117, 125, 128, 137, 138, 139, 147, 148, 150, 153, 154, 166, 173, 194 and 214; and green pigments such as C.I. Pigment Greens 7, 36 and 58 are preferable, and C.I. Pigment Yellows 150 and 185 and C.I. Pigment Green 58 are more preferable.

The content of the colorant (A) is preferably 0.1 to 60 mass%, more preferably 1 to 55 mass%, still more preferably 2 to 50 mass%, based on the total amount of solid contents of the colored resin composition. When the content of the colorant (A) is within the above-described range, the color concentration of the resulting color filter is sufficient, and the composition can be made to contain a required amount of the resin (B), so that it is possible to form a color filter having sufficient mechanical strength. The "total amount of solid contents" herein is an amount obtained by subtracting the content of the solvent from the total amount of the colored resin composition. The total amount of solid contents and the content of each ingredient based on the total amount of solid contents can be measured by known analytical means such as, for example, liquid chromatography or gas chromatography.

### <Resin (B)>

The resin (B) is not particularly limited, and is preferably an alkali-soluble resin. Examples of the resin (B) include the following resins [K1] to [K6].
Resin [K1]: copolymer of at least one selected from the group consisting of an unsaturated carboxylic acid and an unsaturated carboxylic acid anhydride (Ba) (hereinafter, sometimes referred to as "(Ba)") and a monomer (Bb) having a cyclic ether structure having 2 to 4 carbon atoms and an ethylenically unsaturated bond (hereinafter, sometimes referred to as "(Bb)");
Resin [K2]: copolymer of (Ba), (Bb) and a monomer (Bc) polymerizable with (Ba) ((Bc) is different from (Ba) and (Bb)) (hereinafter, sometimes referred to as "(Bc)");
Resin [K3]: copolymer of (Ba) and (Bc);
Resin [K4]: resin obtained by reacting (Bb) with a copolymer of (Ba) and (Bc);
Resin [K5]: resin obtained by reacting (Ba) with a copolymer of (Bb) and (Bc); and
Resin [K6]: resin obtained by reacting (Ba) with a copolymer of (Bb) and (Bc), and reacting the reaction product with carboxylic acid anhydride.

Specific examples of (Ba) include unsaturated monocarboxylic acids such as acrylic acid, methacrylic acid, crotonic acid, and o-, m- and p-vinylbenzoic acids; unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid and 1,4-cyclohexanedicarboxylic acid; bicyclo unsaturated compounds containing carboxy groups, such as methyl-5-norbornene-2,3-dicarboxylic acid, 5-carboybicyclo[2.2.1]-hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene and 5-carboxy-6-ethylbicyclo[2.2.1]hept-2-ene; unsaturated dicarboxylic acid anhydrides such as maleic acid anhydride, citraconic acid anhydride, itaconic acid anhydride, 3-vinylphthalic acid anhydride, 4-vinylphthalic acid anhydride, 3,4,5,6-tetrahydrophthalic acid anhydride, 1,2,3,6-tetrahydrophthalic acid anhydride, dimethyltetrahydrophthalic acid anhydride and 5,6-dicarboxybicyclo[2.2.1]hept-2-ene anhydride; unsaturated mono[(meth)acryloyloxyalkyl]esters of polyvalent carboxylic acids with a valence of 2 or more, such as mono[2-(meth)acryloyloxyethyl] succinate and mono[2-(meth)acryloyloxyethyl] phthalate; and unsaturated acrylates containing a hydroxy group and a carboxy group in one molecule, such as α-(hydroxymethyl)acrylic acid.

Of these, acrylic acid, methacrylic acid, maleic acid anhydride and the like are preferable from the viewpoint of the copolymerization reactivity and the solubility of the resulting resin into an alkaline solution.

(Bb) refers to, for example, a polymerizable compound having a cyclic ether structure having 2 to 4 carbon atoms (for example, at least one selected from the group consisting of an oxirane ring, an oxetane ring and a tetrahydrofuran ring) and an ethylenically unsaturated bond. (Bb) is preferably a monomer which has a cyclic ether having 2 to 4 carbon atoms, and a (meth)acryloyloxy group.

The "(meth)acrylic acid as used herein means at least one selected from the group consisting of acrylic acid and methacrylic acid. The same applies to the "(meth)acryloyl", the "(meth)acrylate" and the like.

Examples of (Bb) include monomers having an oxiranyl group and an ethylenically unsaturated bond, monomers having an oxetanyl group and an ethylenically unsaturated bond, and monomers having a tetrahydrofuryl group and an ethylenically unsaturated bond.

(Bb) is preferably a monomer having an oxiranyl group and an ethylenically unsaturated bond because reliability of heat resistance, chemical resistance and the like of the resulting color filter can be further enhanced.

Examples of (Bc) include (meth)acrylic acid esters such as methyl (meth)acrylate, ethyl (meth)acrylate, n-butyl (meth)acrylate, sec-butyl (meth)acrylate, tert-butyl (meth)acrylate, 2-ethylhexyl (meth)acrylate, dodecyl (meth)acrylate, lauryl (meth)acrylate, stearyl (meth)acrylate, cyclopentyl (meth)acrylate, cyclohexyl (meth)acrylate, 2-methylcyclohexyl (meth)acrylate, tricyclo[5.2.1.0^{2,6}]decan-8-yl (meth)acrylate (referred to as "dicyclopentanyl (meth)acrylate" as a trivial name in the art; sometimes referred to as "tricyclodecyl (meth)acrylate"), tricyclo[5.2.1.0^{2,6}]decen-8-yl (meth)acrylate (referred to as "dicyclopentenyl (meth)acrylate" as a trivial name in the art), dicyclopentanyloxyethyl (meth)acrylate, isobornyl (meth)acrylate, adamantyl (meth)acrylate, allyl (meth)acrylate, propargyl (meth)acrylate, phenyl (meth)acrylate, naphthyl (meth)acrylate and benzyl (meth)acrylate; hydroxy group-containing (meth)acrylic acid esters such as 2-hydroxyethyl (meth)acrylate and 2-hydroxypropyl (meth)acrylate; dicarboxylic acid diesters such as diethyl maleate, diethyl fumarate and diethyl itaconate;
bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene and 5,6-bis(cyclohexyloxycarbonyl)bicyclo[2.2.1]hept-2-ene; dicarbonylimide derivatives such as N-phenylmaleimide, N-cyclohexylmaleimide, N-benzylmaleimide, N-succinimidyl-3-maleimide benzoate, N-succinimidyl-4-maleimide butyrate, N-succinimidyl-6-maleimide caproate, N-succinimidyl-3-maleimide propionate and N-(9-acridinyl)maleimide; and styrene, α-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene and 2,3-dimethyl-1,3-butadiene.

Of these, styrene, vinyltoluene, N-phenylmaleimide, N-cyclohexylmaleimide, N-benzylmaleimide, bicyclo[2.2.1]hept-2-ene and the like are preferable from the viewpoint of copolymerization reactivity and heat resistance.

Specific examples of the resin (B) include the resin [K1] such as 3,4-epoxycyclohexylmethyl (meth)acrylate/(meth)acrylic acid copolymers and 3,4-epoxytricyclo[5.2.1.0^{2.6}]decyl acrylate/(meth)acrylic acid copolymers; the resin [K2] such as glycidyl (meth)acrylate/benzyl (meth)acrylate/(meth)acrylic acid copolymers, glycidyl (meth)acrylate/styrene/(meth)acrylic acid copolymers, 3,4-epoxytricyclo[5.2.1.0^{2.6}]decyl acrylate/(meth)acrylic acid/N-cyclohexylmaleimide copolymers and 3-methyl-3-(meth)acryloyloxymethyloxetane/(meth)acrylic acid/styrene copolymers; the resin [K3] such as benzyl (meth)acrylate/(meth)acrylic acid copolymers and styrene/(meth)acrylic acid copolymers; the resin [K4] such as resins obtained by adding glycidyl (meth)acrylate to a benzyl (meth)acrylate/(meth)acrylic acid copolymer, resins obtained by adding glycidyl (meth)acrylate to a tricyclodecyl (meth)acrylate/styrene/(meth)acrylic acid copolymer, and resins obtained by adding glycidyl (meth)acrylate to a tricyclodecyl (meth)acrylate/benzyl (meth)acrylate/(meth)acrylic acid copolymer; the resin [K5] such as resins obtained by reacting (meth)acrylic acid with a copolymer of tricyclodecyl (meth)acrylate/glycidyl (meth)acrylate, and resins obtained by reacting (meth)acrylic acid with a copolymer of tricyclodecyl (meth)acrylate/styrene/glycidyl (meth)acrylate; and the resin [K6] such as resins obtained by reacting (meth)acrylic acid with a copolymer of tricyclodecyl (meth)acrylate/glycidyl (meth)acrylate, and reacting the thus-obtained resin with tetrahydrophthalic acid anhydride.

In particular, the resin [K1] and the resin [K2] are preferable as the resin (B).

For example, the resin [K1] can be produced with reference to the methods disclosed in the document "Experimental Methods for Synthesis of Polymers" (Takayuki Otsu, published by Kagaku-Dojin Publishing Company, INC., Vol. 1, First Printing, published on March 1, 1972) and the cited documents described in the above-mentioned document.

The resulting copolymer may be used in the form of a solution after reaction itself, in the form of a solution obtained by concentration or dilution of the solution after reaction, or in the form of a solid (powder) extracted by a method such as reprecipitation. In particular, when a solvent which is contained in the colored resin composition of the present invention is used as a solvent during the polymerization, the solution after reaction can be used directly for preparation of the colored resin composition of the present invention, so that it is possible to simplify the process for production of the colored resin composition of the present invention.

The weight average molecular weight of the resin (B) in terms of polystyrene is preferably 3,000 to 100,000, more preferably 5,000 to 50,000, still more preferably 5,000 to 30,000. When the molecular weight is within the above-described range, there is a tendency that the hardness of the color filter is enhanced, the residual film ratio is high, good solubility of unexposed areas in a developer is obtained, and the resolution of the colored pattern is improved.

The molecular weight distribution [weight average molecular weight (Mw)/number average molecular weight (Mn)] of the resin (B) is preferably 1.1 to 6, more preferably 1.2 to 4.

The acid value of the resin (B) is preferably 50 to 170 mg-KOH/g, more preferably 60 to 150 mg-KOH/g, still more preferably 70 to 135 mg-KOH/g. Here, the acid value is a value measured as the amount (mg) of potassium hydroxide necessary for neutralizing 1 g of the resin (B), and can be determined by performing titration with, for example, a potassium hydroxide aqueous solution.

The content percentage of the resin (B) is 70 mass% or more, preferably 90 mass% or more, more preferably 95 mass% or more, based on an amount obtained by subtracting the content of the colorant (A) and the solvent (E) from the total amount of the colored resin composition. When the content percentage of the resin (B) is within the above-described range, the content ratio of ingredients other than the colorant (A) and the solvent (E) is limited, so that it is possible to obtain a color filter having high heat resistance. The content of the resin (B) is preferably 50 mass% or more, more preferably 60 mass% or more, based on the total amount of solid contents of the colored resin composition.

### <Solvent (E)>

The solvent (E) is not particularly limited, and a solvent which is typically used in the art can be used. Examples of the solvent include ester solvents (solvents which contain -COO- and do not contain -O- in the molecule), ether solvents (solvents which contain -O- and do not contain -COO- in the molecule), ether ester solvents (solvents which contain -COO- and -O- in the molecule), ketone solvents (solvents which contain -CO- and do not contain -COO- in the molecule), alcohol solvents (solvents which contain OH and do not contain - O-, -CO- and -COO- in the molecule), aromatic hydrocarbon solvents, amide solvents and dimethyl sulfoxide.

Examples of the ester solvent include methyl lactate, ethyl lactate, butyl lactate, methyl 2-hydroxyisobutanoate, ethyl acetate, n-butyl acetate, isobutyl acetate, pentyl formate, isopentyl acetate, butyl propionate, isopropyl butyrate, ethyl butyrate, butyl butyrate, methyl pyruvate, ethyl pyruvate, propyl pyruvate, methyl acetoacetate, ethyl acetoacetate, cyclohexanol acetate and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetole and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypripionate, ethyl 3-methoxypripionate, methyl 3-ethoxypropionate, ethyl 3-ethoxypropionate, methyl 2-methoxypropionate, ethyl 2-methoxypropionate, propyl 2-methoxypropionate, methyl 2-ethoxypropionate, ethyl 2-ethoxypropionate, methyl 2-methoxy-2-methylpropionate, ethyl 2-ethoxy-2-methylpropionate, 3-methoxybutyl acetate, 3-methyl-3-methoxybutyl acetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate and diethylene glycol monobutyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone and isophorone.

Examples of the alcohol solvent include methanol, ethanol, propanol, butanol, hexanol, cyclohexanol, ethylene glycol, propylene glycol and glycerin.

Examples of the aromatic hydrocarbon solvent include benzene, toluene, xylene and mesitylene.

Examples of the amide solvent include N,N-dimethylformamide, N,N-dimethylacetamide and N-methylpyrrolidone.

Of the above-described solvents, organic solvents having a boiling point of 120°C or more and 210°C or less at 1 atm are preferable from the viewpoint of coating properties and drying properties. The solvent is preferably propylene glycol monomethyl ether acetate, ethyl lactate, propylene glycol monomethyl ether, ethyl 3-ethoxypropionate, ethylene glycol monomethyl ether, diethylene glycol monomethyl ether, diethylene glycol monoethyl ether, 4-hydroxy-4-methyl-2-pentanone or N,N-dimethylformamide, more preferably propylene glycol monomethyl ether acetate, propylene glycol monomethyl ether, N,N-dimethylformamide, N-methylpyrrolidone or ethyl 3-ethocypropionate.

The content of the solvent (E) is preferably 70 to 95 mass%, more preferably 75 to 92 mass%, based on the total amount of the colored resin composition of the present invention. In other words, the total amount of solid contents of the colored resin composition is preferably 5 to 30 mass%, more preferably 8 to 25 mass%.

When the content of the solvent (E) is within the above-described range, flatness during coating tends to be improved.

### <Leveling Agent (F)>

Examples of the leveling agent (F) include silicone-based surfactants, fluorine-based surfactants, and silicone-based surfactants having fluorine atoms. These surfactants may have polymerizable groups on the side chain.

Examples of the silicone-based surfactant include surfactants having a siloxane bond in the molecule. Specific examples thereof include Toray Silicones DC3PA, SH7PA, DC11PA, SH21PA, SH28PA, SH29PA, SH30PA and SH8400 (trade name) (manufactured by Dow Corning Toray Co., Ltd.), KP321, KP322, KP323, KP324, KP326, KP340 and KP341 (manufactured by Shin-Etsu Chemical Co., Ltd.), and TSF400, TSF401, TSF410, TSF4300, TSF4440, TSF4445, TSF-4446, TSF4452 and TSF4460 (manufactured by Momentive Performance Materials Japan LLC).

Examples of the fluorine-based surfactant include surfactants having a fluorocarbon chain in the molecule. Specific examples thereof include FLUORAD (R) FC430 and FC431 (manufactured by Sumitomo 3M Ltd.), MEGAFAC (R) F142D, F171, F172, F173, F177, F183, F554, R30 and RS-718-K (manufactured by DIC Corporation), FTOP (R) EF301, EF303, EF351 and EF352 (manufactured by Mitsubishi Materials Electronic Chemicals Co., Ltd.), SURFLON (R) S381, S382, SC101 and SC105 (manufactured by AGC Inc.) and E5844 (manufactured by Daikin Fine Chemical Laboratory Co., Ltd.).

Examples of the silicone-based surfactant having fluorine atoms include surfactants having a siloxane bond and a fluorocarbon chain in the molecule. Specific examples thereof include MEGAFAC (R) R08, BL20, F475, F477 and F443 (manufactured by DIC Corporation).

The content of the leveling agent (F) is preferably 0.001 parts by mass or more and 0.2 parts by mass or less, preferably 0.002 parts by mass or more and 0.1 parts by mass or less, more preferably 0.005 parts by mass or more and 0.05 parts by mass or less, per 100 parts by mass of the content of the resin (B). When the content of the leveling agent (F) is within the above-described range, the flatness of the color filter can be improved.

### <Method for Producing Colored Resin Composition>

The colored resin composition of the present invention can be prepared by, for example, mixing the colorant (A), the resin (B) and the solvent (E) as well as the leveling agent (F) and other ingredients to be used if necessary.

When the colored resin composition contains the pigment (P), it is preferable that the pigment (P) be mixed with part or all of the solvent (E), and then dispersed using a bead mill or the like until the average particle size of the pigment is about 0.2 µm or less. Here, part or all of the pigment dispersant and the resin (B) may be blended if necessary. By mixing the thus-obtained pigment dispersion with the residual ingredients so as to obtain a predetermined concentration, an intended colored resin composition can be prepared.

The dye may be dissolved beforehand in part or all of the solvent (E) to prepare a solution. Preferably, the solution is filtered with a filter having a pore size of about 0.01 to 1 µm.

Preferably, the colored resin composition after the mixing is filtered with a filter having a pore size of about 0.1 to 10 µm.

### <Method for Producing Color Filter>

Examples of methods for producing a color filter from the colored resin composition of the present invention include a method in which the colored resin composition is applied onto a substrate, and dried under heating (pre-baked) and/or dried under reduced pressure to remove volatile ingredients such as a solvent, and thus a smooth colored composition layer is formed, followed by performing post-baking. The colored cured film formed in this way may be the color filter of the present invention.

As the substrate, a glass plate made of quarts glass, borosilicate glass, alumina-silicate glass, soda-lime glass having a silica-coated surface, or the like, a resin plate made of polycarbonate, polymethyl methacrylate, polyethylene terephthalate or the like, a silicon plate, or a plate obtained by forming an aluminum, silver or silver-copper-palladium alloy thin film, or the like on any of the aforementioned substrates is used. On such a substrate, another color filter layer, a resin layer, a transistor, a circuit and the like may be formed.

Examples of coating methods include a spin coating, a slit coating method, and a slit-and-spin coating method.

The temperature at which drying is performed under heating is preferably 30 to 120°C, more preferably 50 to 110°C. The heating time is preferably 10 seconds to 60 minutes, more preferably 30 seconds to 30 minutes.

When the composition is dried under reduced pressure, it is preferable to perform the drying at a temperature of 20 to 25°C under a pressure of 50 to 150 Pa.

The thickness of the colored resin composition is not particularly limited, and may be appropriately selected according to the thickness of an intended color filter.

Preferably, the resulting colored resin composition film is post-baked. The post-baking temperature is preferably 150 to 250°C, more preferably 160 to 235°C. The post-baking time is preferably 1 to 120 minutes, more preferably 10 to 60 minutes.

The thickness of the resulting color filter is not particularly limited, and can be appropriately adjusted according to a purpose, a use and the like. For example, the thickness is 0.1 to 30 µm, preferably 0.1 to 20 µm, more preferably 0.5 to 6 µm.

The thus-obtained cured coating film can be patterned by, for example, an etching method.

The colored resin composition of the present invention is capable of forming a color filter excellent in heat resistance. The color filter is useful as a color filter to be used for display devices (for example, liquid crystal display devices, organic EL devices and electronic papers) and solid-state image sensors.

### Examples

Hereinafter, the present invention will be described in more detail by way of Examples, which should not be construed as limiting the present invention. In Examples, the term "%" and the term "parts" for expressing the content or the used amount are by mass unless otherwise specified.

In Synthesis Examples below, the structures of compounds were identified by NMR (JNM-EX-270 (manufactured by JEOL Ltd.)).

### <Synthesis Example 1: Synthesis of Squarylium Dye a1>

10.0 parts of 2,4-dimethylaniline (manufactured by Tokyo Chemical Industry Co., Ltd.), 17.0 parts of 2-ethylhexane bromide (manufactured by Tokyo Chemical Industry Co., Ltd.) and 44.0 parts of tetrabutylammonium bromide (manufactured by Wako Kagaku Kogyo K.K.) were mixed. The resulting mixture was stirred at 90°C for 8 hours. After completion of the reaction, 50 parts of 10% sodium bicarbonate water was added, 100 parts of ethyl acetate was then added, and the aqueous layer was discarded. The operation of washing with water and 10% chloric acid was repeated twice, and the solvent was then distilled away. The obtained oil was dried under reduced pressure at 60°C for 24 hours to give 9.3 parts of a compound represented by the following formula (d-1).

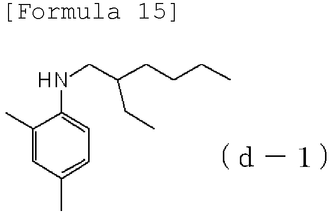

¹H-NMR of the compound represented by formula (d-1) (270 MHz, δ value (ppm, referenced to TMS), DMSO-d6) 0.85 (m, 6H), 1.23-1.42 (br, 8H), 1.59 (br, 1H), 2.04 (s, 3H), 2.12 (s, 3H), 2.91 (d, 2H), 4.37 (br, 1H), 6.38 (d, 1H), 6.75 (s, 1H), 6.77 (d, 1H)

3.0 parts of the thus-obtained compound (d-1), 2.2 parts of 3-bromophenol (manufactured by Tokyo Chemical Industry Co., Ltd.), 0.015 parts of palladium acetate, 3.2 parts of (tert-butoxy)sodium (manufactured by Tokyo Chemical Industry Co., Ltd.), 0.055 parts of tri-tert-butylphosphine and 25.6 parts of toluene were mixed, and the resulting mixture was stirred at 100°C for 15 hours. 30 parts of ethyl acetate and 100 parts of water were added to the resulting mixture, and the aqueous layer was discarded. The operation of washing with water was repeated twice, and the solvent was then distilled away. The residue was purified by silica gel chromatography (chloroform/hexane = 1/1), and the obtained oil was dried under reduced pressure at 60°C for 24 hours to give 1.9 parts of a compound represented by the following formula (d-2).

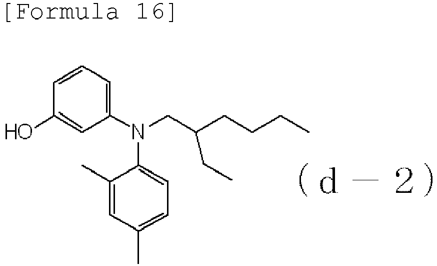

¹H-NMR of the compound represented by formula (d-2) (270 MHz, δ value (ppm, referenced to TMS), DMSO-d6) 0.85 (m, 6H), 1.23-1.42 (br, 8H), 1.55 (br, 1H), 1.94 (s, 3H), 2.27 (s, 3H), 2.90 (d, 2H), 6.37 (d, 1H), 6.75 (s, 1H), 6.76 (d, 1H), 6.92-7.14 (m, 4H), 8.93 (s, 1H)

4.4 parts of the thus-obtained compound represented by formula (d-2), which is an intermediate, 0.8 parts of 3,4-dihydroxy-3-cyclobuten-1,2-dione (manufactured by Tokyo Chemical Industry Co., Ltd.), 90.0 parts of 1-butanol and 60.0 parts of toluene were mixed. The resulting mixture was stirred at 125°C for 3 hours while water generated was removed using a Dean-Stark tube. After completion of the reaction, the solvent was distilled away, 15 parts of acetic acid was added, the resulting mixture was then added dropwise to 100 parts of a 18% salt solution, and the precipitated solid was taken by filtration. The solid taken by filtration was washed with hexane. The obtained solid was dried under reduced pressure at 60°C for 24 hours to give 4.9 parts of a compound (squarylium dye a1) represented by formula (AII-8).

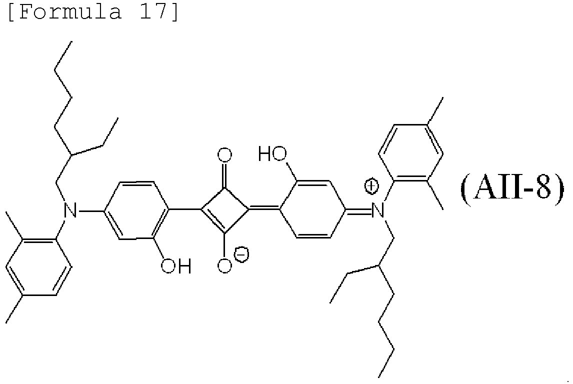

¹H-NMR of the compound represented by formula (AII-8) (270 MHz, δ value (ppm, referenced to TMS), DMSO-d6) 0.87 (m, 12H), 1.21-1.57 (m, 16H), 1.72 (br, 2H), 2.05 (s, 6H), 2.36 (s, 6H), 3.37 (br, 2H), 3.78 (br, 2H), 6.00 (br, 4H), 6.97-7.12 (m, 6H), 7.77-7.95 (m, 2H), 11.35 (s, 1H), 12.06 (s, 1H)

### <Synthesis Example 2: Synthesis of Yellow Dye a2>

A compound (yellow dye b2) represented by the following formula was produced by a method for producing a compound represented by formula (Ad2-14) as disclosed in Japanese Patent Laid-Open No. 2016-11419. The compound represented by the following formula is the same compound as the compound represented by formula (Ad2-14) in Japanese Patent Laid-Open No. 2016-11419.

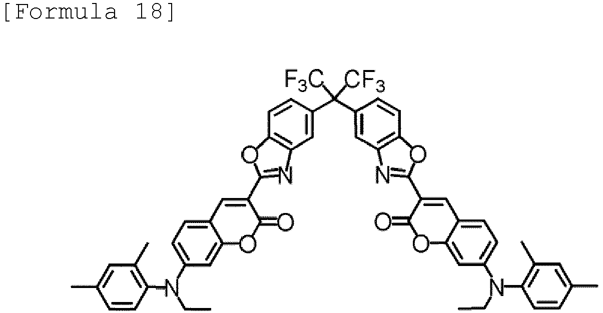

### <Synthesis Example 3: Synthesis of Resin b1>

The inside of a flask equipped with a reflux condenser, a dropping funnel and a stirrer was brought into a nitrogen atmosphere by feeding an appropriate amount of nitrogen into the flask, and 100 parts of propylene glycol monomethyl ether acetate was put in the flask, and heated to 85°C with stirring. Subsequently, a solution obtained by dissolving 19 parts of methacrylic acid and a mixture of 171 parts of a mixture of 3,4-epoxytricyclo[5.2.1.0^{2.6}]decan-8-yl acrylate and 3,4-epoxytricyclo[5.2.1.0^{2.6}]decan-9-yl acrylate (content ratio: 50 : 50 in terms of molar ratio) in 40 parts of propylene glycol monomethyl ether acetate was added dropwise into the flask over about 5 hours using a dropping pump. On the other hand, a solution obtained by dissolving 26 parts of 2,2'-azobis(2,4-dimethylvaleronitrile) as a polymerization initiator in 120 pars of propylene glycol monomethyl ether acetate was added dropwise into the flask over about 5 hours using another dropping pump. After completion of the dropwise addition of the polymerization initiator, the resulting mixture was held at the same temperature for about 3 hours, and then cooled to room temperature to give a resin b1 solution having a solid content of 43.5%.

The obtained resin b1 had a weight average molecular weight of 8000, a molecular weight distribution of 1.98 and an acid value of 53 mg-KOH/g in terms of solid content. The resin b1 has the structural units shown below.

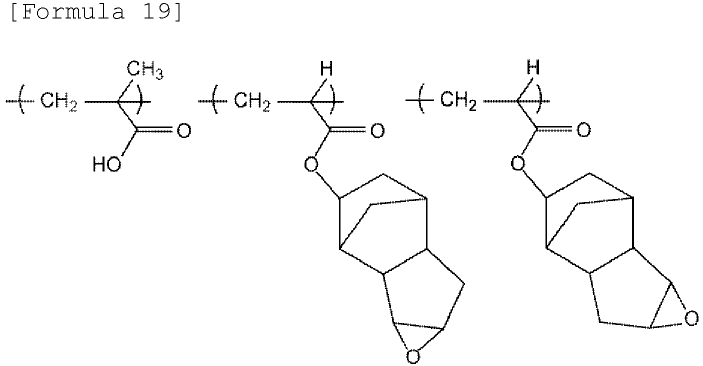

The weight average molecular weight (Mw) and the number average molecular weight (Mn) of the resin b1 in terms of polystyrene were measured by a GPC method under the following conditions. The same applies to the following resins b2 to b3.

| |
|---|
| Apparatus: HLC-8120GPC (manufactured by TOSOH Corporation) |
| Column: TSK-GELG2000HXL |
| Column temperature: 40°C |
| Solvent: THF |
| Flow rate: 1.0 mL/min |
| Test liquid solid content concentration: 0.001 to 0.01 mass% |
| Injection amount: 50 µL |
| Detector: RI |

Standard substances for calibration: TSK STANDARD POLYSTYRENE F-40, F-4, F-288, A-2500 and A-500 (manufactured by TOSOH Corporation)

The ratio between the thus-obtained weight average molecular weight and number average molecular weight (Mw/Mn) in terms of polystyrene was defined as a molecular weight distribution.

### <Synthesis Example 4-1: Synthesis of Resin b2a>

The inside of a flask equipped with a reflux condenser, a dropping funnel and a stirrer was brought into a nitrogen atmosphere by feeding an appropriate amount of nitrogen into the flask, and 290 parts of propylene glycol monomethyl ether acetate was put in the flask, and heated to 85°C with stirring. Subsequently, a mixed solution of 94 parts of a mixture of 3,4-epoxytricyclo[5.2.1.0^{2.6}]decan-8-yl acrylate and 3,4-epoxytricyclo[5.2.1.0^{2.6}]decan-9-yl acrylate (content ratio: 1 : 1), 61 parts of 4-vinylbenzoic acid, 157 parts of phenyl methacrylate and 250 parts of propylene glycol monomethyl ether acetate was added dropwise over 4 hours.

On the other hand, a mixed solution obtained by dissolving 9 parts of 2,2-azobis(2,4-dimethylvaleronitrile) in 110 parts of propylene glycol monomethyl ether acetate was added dropwise over 5 hours. After completion of the dropwise addition, the inside of the flask was held at 85°C for 3 hours, and then cooled to room temperature to give a copolymer (resin b2a) solution having a B-type viscosity of 70 mPas (23°C) and a solid content of 28.2 %. The generated copolymer had a weight average molecular weight Mw of 17000 and a degree of dispersion of 2.23. The resin b2a has the structural units shown below.

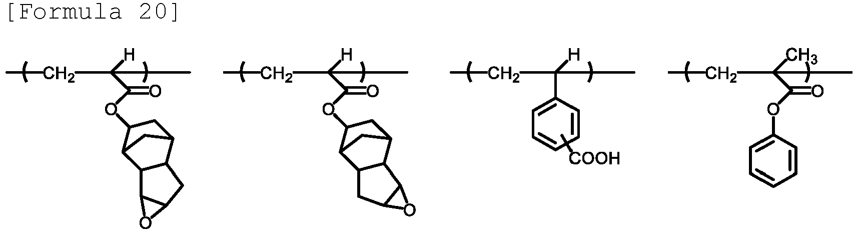

### <Synthesis Example 4-2: Synthesis of Resin b2b>

The inside of a flask equipped with a reflux condenser, a dropping funnel and a stirrer was brought into a nitrogen atmosphere by feeding an appropriate amount of nitrogen into the flask, and 306 parts of propylene glycol monomethyl ether acetate was put in the flask, and heated to 80°C with stirring. Subsequently, a mixed solution of 57 parts of a mixture of 3,4-epoxytricyclo[5.2.1.0^{2.6}]decan-8-yl acrylate and 3,4-epoxytricyclo[5.2.1.O^{2.6}]decan-9-yl acrylate (content ratio: 1 : 1), 47 parts of 4-vinylbenzoic acid, 155 parts of phenyl methacrylate and 176 parts of propylene glycol monomethyl ether acetate was added dropwise over 3 hours.

On the other hand, a mixed solution obtained by dissolving 3 parts of 2,2-azobis(2,4-dimethylvaleronitrile) in 87 parts of propylene glycol monomethyl ether acetate was added dropwise over 5 hours. After completion of the dropwise addition, the inside of the flask was held at 85°C for 3 hours, and then cooled to room temperature to give a copolymer (resin b2b) solution having a B-type viscosity of 150 mPas (23°C) and a solid content of 27.6 %. The generated copolymer had a weight average molecular weight Mw of 41000 and a degree of dispersion of 2.94. The resin b2b has the structural units shown below.

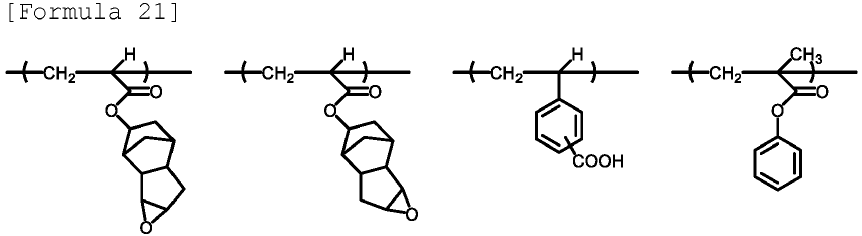

### <Synthesis Example 5: Synthesis of Resin b3>

200 parts of propylene glycol monomethyl ether acetate was introduced into a flask equipped with a stirrer, a thermometer, a reflux condenser tube, a dropping funnel and a gas inlet tube. Thereafter, nitrogen gas was introduced into the flask through the gas inlet tube to replace the atmosphere in the flask with the nitrogen gas. The solution in the flask was heated to 70°C, and a mixture of 144 parts of benzyl methacrylate, 30 parts of tricyclo[5.2.1.02.6]decyl methacrylate, 42 parts of acrylic acid, 5.2 parts of azobisisobutyronitrile and 213 parts of propylene glycol monomethyl ether acetate was then added dropwise into the flask over 2 hours using the dropping funnel. After completion of the dropwise addition, the resulting mixture was stirred at 100°C for 5 hours. After completion of the dropwise addition of the polymerization initiator, the resulting mixture was held at 70°C for 4 hours, and then cooled to room temperature to give a copolymer (resin b3) solution having a solid content of 34.1%. The resin b3 had a weight average molecular weight of 1.13 × 10⁴, a molecular weight distribution of 2.18 and an acid value of 108.5 mg-KOH/g in terms of solid content. The resin b3 has the structural units shown below.

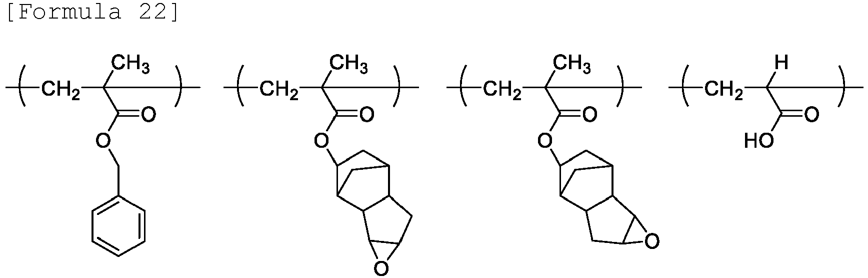

### [Preparation of Green Colored Resin Composition]

Green colored resin compositions were obtained by mixing the ingredients in accordance with the compositions shown in Tables 2 and 3 below. The compositions shown in Tables 2 and 3 each represent an amount in terms of solid content except for the solvent (E). The amount obtained by subtracting the content of the colorant (A) and the solvent (E) from the total amount of the green colored resin composition is defined as a reference amount (S), and the content percentage of the resin (B) to the reference amount (S) is described as a "content percentage of the resin (B)".

The ingredients in Tables 2 and 3 are shown below.
Squarylium dye a1: compound synthesized in Synthesis Example 1
Yellow pigment: C.I. Pigment Yellow 150
Yellow dye a2: compound synthesized in Synthesis Example 2
Yellow dye a3: mixture of the following compounds disclosed in Japanese Patent Laid-Open No. 2012-31218 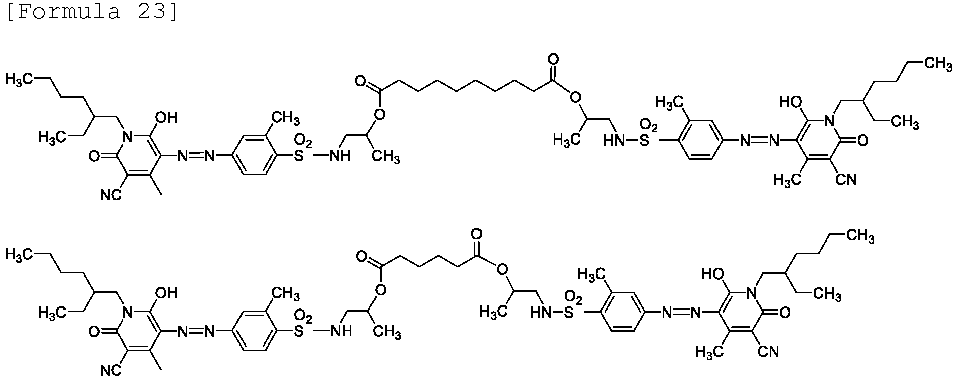
Resin b1: resin synthesized in Synthesis Example 3
Resin b2a: resin synthesized in Synthesis Example 4-1
Resin b2b: resin synthesized in Synthesis Example 4-2
Resin b3: resin synthesized in Synthesis Example 5
Solvent e1: propylene glycol monomethyl ether acetate
Solvent e2: N-methyl-2-pyrrolidone
Leveling agent f1: MEGAFAC (R) F554 (manufactured by DIC Corporation)

### [Formation of Coating Film]

The green colored resin composition prepared in each of Examples 1 to 13 and Comparative Example 1 was applied onto a glass substrate of 5 cm square (EAGLE XG; manufactured by Corning Inc.) by a spin coating method so as to have a thickness of 0.5 µm after post-baking, and then pre-baked on a hot plate at 70°C for 1 hour to give a colored coating film (hereinafter, referred to as a "colored coating film before post-baking). Thereafter, the film was post-baked on a hot plate at 220°C for 10 minutes to give a colored coating film (hereinafter, referred to as a "colored coating film after post-baking").

### <Evaluation of Heat Resistance>

X and Y of x-y chromaticity coordinates (x, y) for the colored coating film before post-baking and the colored coating film after post-baking were measured, and from the measured values, a color difference ΔE*ab before and after post-baking was calculated by the method disclosed in JIS Z 8730: 2009 (7. Method for Calculation of Color Difference). Tables 2 and 3 show the results. The colored coating film is acceptable in practical use as a color filter as long as the color difference ΔE*ab of the colored film is 10 or less.

**[Table 2]**

| | | Ex. 1 | Ex. 2 | Ex. 3 | Ex. 4 | Ex. 5 | Ex. 6 | Ex. 7 | Ex. 8 |
|---|---|---|---|---|---|---|---|---|---|
| Colorant (A) | Squarylium dye a1 (parts by mass) | 2.5 | 2.5 | 2.5 | 2.5 | 2.5 | 2.5 | 2.5 | 2.5 |
| | Yellow pigment | | | | | | | | |
| | Yellow dye a2 (parts by mass) | | | | | 28 | 28 | 28 | 28 |
| | Yellow dye a3 (parts by mass) | | | | | | | | |
| Resin (B) | Resin b1 (parts by mass) | 100 | | | | 100 | | | |
| | Resin b2a (parts by mass) | | 100 | | | | 100 | | |
| | Resin b2b (parts by mass) | | | 100 | | | | 100 | |
| | Resin b3 (parts by mass) | | | | 100 | | | | 100 |
| Polymerizable compound | Polymerizable compound c1 (parts by mass) | | | | | | | | |
| Polymerization initiator | Polymerization initiator d1 (parts by mass) | | | | | | | | |
| Leveling agent | Leveling agent f1 (parts by mass) | 0.1 | 0.1 | 0.1 | 0.1 | 0.1 | 0.1 | 0.1 | 0.1 |
| Dispersant | | | | | | | | | |
| Solvent (E) | Solvent e1 (parts by mass) | 1280 | 1280 | 1280 | 1280 | 1280 | 1280 | 1280 | 1280 |
| | Solvent e2 (parts by mass) | 154 | 154 | 154 | 154 | 154 | 154 | 154 | 154 |
| Content percentage of resin (B) (mass%) | | 99.9 | 99.9 | 99.9 | 99.9 | 99.9 | 99.9 | 99.9 | 99.9 |
| Color difference AE * ab | | 0.42 | 1.85 | 2.44 | 0.64 | 3.81 | 3.61 | 4.91 | 2.30 |

**[Table 3]**

| | | Example 9 | Example 10 | Example 11 | Example 12 | Comparative Example 1 |
|---|---|---|---|---|---|---|
| Colorant (A) | Squarylium dye a1 (parts by mass) | 2.5 | 2.5 | 2.5 | 2.5 | 2.5 |
| | Yellow pigment | | | | | 28 |
| | Yellow dye a2 (parts by mass) | | | | | |
| | Yellow dye a3 (parts by mass) | 28 | 28 | 28 | 28 | |
| Resin (B) | Resin b1 (parts by mass) | 100 | | | | 50 |
| | Resin b2a (parts by mass) | | 100 | | | |
| | Resin b2b (parts by mass) | | | 100 | | |
| | Resin b3 (parts by mass) | | | | 100 | |
| Polymerizable compound | Polymerizable compound c1 (parts by mass) | | | | | 50 |
| Polymerization initiator | Polymerization initiator d1 (parts by mass) | | | | | 10 |
| Leveling agent | Leveling agent f1 (parts by mass) | 0.1 | 0.1 | 0.1 | 0.1 | 0.1 |
| Dispersant | | | | | | 13 |
| Solvent (E) | Solvent e1 (parts by mass) | 1280 | 1280 | 1280 | 1280 | 1280 |
| | Solvent e2 (parts by mass) | 154 | 154 | 154 | 154 | 154 |
| Content percentage of resin (B) (mass%) | | 100 | 100 | 100 | 100 | 40.6 |
| Color difference ΔE*ab | | 2.72 | 5.83 | 1.93 | 1.82 | 29.01 |

As shown in Tables 2 and 3, the colored films of Examples 1 to 12 using the green colored resin composition of the present invention had a smaller color difference ΔE*ab before and after post-baking as compared to the colored film of Comparative Example 1, and were excellent in heat resistance.

## Claims

1. A green colored resin composition comprising a colorant, a resin and a solvent, wherein
the colorant comprises a squarylium dye, and
the content of the resin is 70 mass% or more based on an amount obtained by subtracting the content of the colorant and the solvent from the total amount of the green colored resin composition.

2. The green colored resin composition according to claim 1, wherein the squarylium dye is a compound represented by formula (II): 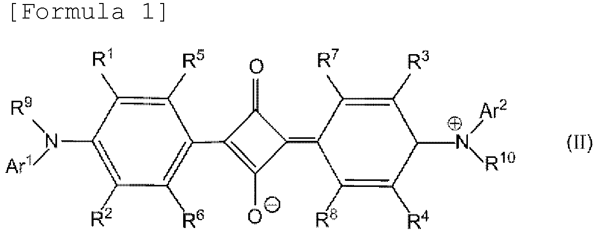
wherein R¹ to R⁴ each independently represent a hydrogen atom, a halogen atom, a hydroxy group, or a monovalent saturated hydrocarbon group having 1 to 20 carbon atoms;
a hydrogen atom or a methyl group contained in the monovalent saturated hydrocarbon group is optionally replaced by a halogen atom, a hydroxy group or an alkylamino group having 1 to 8 carbon atoms, and an oxygen atom or a sulfur atom is optionally intercalated between carbon atoms that form the monovalent saturated hydrocarbon group;
R⁵ to R⁸ each independently represent a hydrogen atom or a hydroxy group;
Ar¹ and Ar² each independently represent a group represented by the following formula (i): 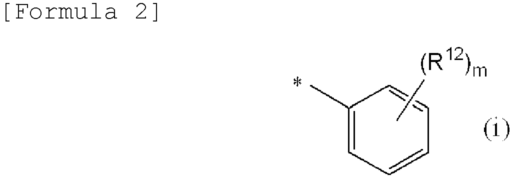
wherein R¹² represents a monovalent saturated hydrocarbon group having 1 to 20 carbon atoms or a monovalent unsaturated hydrocarbon group having 2 to 20 carbon atoms, and m represents an integer of 1 to 5; when m is 2 or more, a plurality of R¹² may be the same or different;
and * represents a point of attachment to a nitrogen atom;
R⁹ and R¹⁰ each independently represent a monovalent saturated hydrocarbon group having 1 to 20 carbon atoms, or a group represented by formula (i); and a hydrogen atom or a methyl group contained in the monovalent saturated hydrocarbon group is optionally replaced by a halogen atom, a hydroxy group, or an amino group substituted with one or two alkyl groups having 1 to 8 carbon atoms, and an oxygen atom or a sulfur atom is optionally intercalated between carbon atoms that form the monovalent saturated hydrocarbon group].

3. The green colored resin composition according to claim 1 or 2, wherein the colorant further comprises a dye other than a squarylium dye.

4. A color filter formed of the green colored resin composition according to claims 1 to 3.
